# Europäisches Patentamt

# European Patent Office

# Office européen des brevets

(11) Veröffentlichungsnummer: **0 025 176**
A2

(12) **EUROPÄISCHE PATENTANMELDUNG**

(21) Anmeldenummer: **80105069.1**

(22) Anmeldetag: **26.08.80**

(51) Int. Cl.³: **H 01 L 27/10**
**G 06 G 7/14, H 01 L 29/78**

(30) Priorität: **11.09.79 DE 2936728**

(43) Veröffentlichungstag der Anmeldung:
**18.03.81 Patentblatt 81/11**

(84) Benannte Vertragsstaaten:
**BE FR GB IT NL**

(71) Anmelder: **SIEMENS AKTIENGESELLSCHAFT Berlin und München**
**Postfach 22 02 61**
**D-8000 München 22(DE)**

(72) Erfinder: **Koch, Rudolf, Dipl.-Ing**
**Nimrodstrasse 42**
**D-8034 Germering(DE)**

(54) **Integrierte Schaltung zur Differenzbildung zwischen zwei Ladungen.**

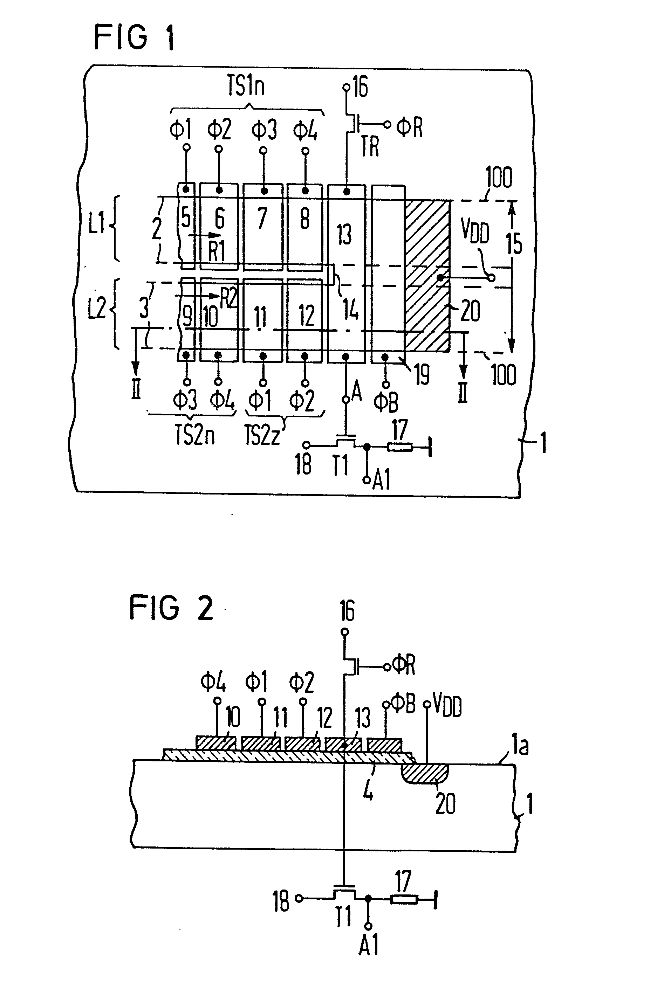

(57) Integrierte Schaltung zur Differenzbildung zwischen zwei Ladungen. Es wird angestrebt, zwei in zwei nebeneinander-liegenden CTD-Anordnungen transportierte Ladungspakete der Differenzbildung zugrundezulegen. Zu diesem Zweck dient ein belden CTD-Anordnungen gemeinsames "floating gate", das beim Abtransport des erstem Ladungspakets eine erste Potentialänderung und beim Zubringen des zweiten Ladungspakets eine zweite, zu der ersten entgegengesetzte Potentialänderung erfährt und mit dem Schaltungsausgang in Verbindung steht. Vorteilhaft ist die leichte Integrierbarkeit der Schaltung, die einen gemeinsamen Bestandteil bei der CTD's darstellt. Der Anwendungsbereich umfaßt Anordnungen für die analoge Signalverarbeitung. (Figur 1)

FIG 1

SIEMENS AKTIENGESELLSCHAFT         Unser Zeichen
Berlin und München                 VPA
                                   79 P 7 1 5 8

Integrierte Schaltung zur Differenzbildung zwischen
zwei Ladungen.

Die Erfindung bezieht sich auf eine integrierte Schaltung
zur Differenzbildung zwischen zwei Ladungen nach dem Oberbegriff des Anspruchs 1.

Eine solche Schaltung ist beispielsweise aus den IEEE
Transactions on Electron Devices, Vol. ED -24, No. 6,
Juni 1977, Seiten 746 bis 750, bekannt. Dort erfolgt
die Differenzbildung mittels eines Differenzverstärkers,
dessen positiver Eingang mit der Ausgangsstufe einer
ersten CCD-Anordnung und dessen negativer Eingang mit der
Ausgangsstufe einer zweiten CCD-Anordnung verbunden ist.
Unter CCD-Anordnung wird hierbei eine ladungsgekoppelte
Vorrichtung (Charge Coupled Device) verstanden. Der
Differenzverstärker erfordert jedoch einen beträchtlichen
Schaltungsaufwand und für den Fall einer monolithischen
Integration eine große Halbleiterfläche.

Der Erfindung liegt die Aufgabe zugrunde, bei einer inte-

St 1 Plr/6.9.1979

grierten Schaltung zur Differenzbildung zwischen zwei Ladungen der eingangs genannten Art die erwähnten Schwierigkeiten zu beheben. Diese Aufgabe wird durch die im Anspruch 1 gekennzeichneten Merkmale gelöst.

Andererseits ist aus der DE-OS 28 11 146 ein auf einem Halbleiterkörper integrierter Schaltkreis zur Differenzbildung von elektrischen Ladungen bekannt, bei dem zwei zu messende Ladungen in einer CCD-Anordnung in die durch eine Elektrode mit frei einstellbarem Potential und das darunter liegende Halbleitergebiet gebildete Kapazität gebracht und daraus entfernt werden und die entsprechende Potentialdifferenz an der Elektrode gemessen wird. Im Gegensatz zur Erfindung werden die Ladungen jedoch nicht in zwei CCD-Anordnungen verschoben, sondern nacheinander in einer einzigen.

Der mit der Erfindung erzielbare Vorteil besteht insbesondere darin, daß die differenzbildende Schaltung einen in einfacher Weise zu realisierenden gemeinsamen Bestandteil beider CTD-Anordnungen (Charge Transfer Device) darstellt, der nur einen sehr kleinen Anteil an Halbleiterfläche erfordert.

Die Erfindung wird nachfolgend anhand der Zeichnung näher erläutert. Dabei zeigt:

Figur 1 eine nach der Erfindung ausgebildete Schaltung,

Figur 2 einen Querschnitt der Schaltung nach Figur 1,

Figur 3 Spannungs-Zeit-Diagramme zur Erläuterung der Schaltung nach Figur 1 und

Figur 4 eine zweite nach der Erfindung ausgebildete Schaltung.

In Figur 1 ist eine auf einem dotierten Halbleiterkörper 1, z. B. aus p-leitendem Silizium, integrierte Schaltung mit zwei CTD-Anordnungen L1 und L2 dargestellt. Die lateralen Begrenzungen des Übertragungskanals von L1 sind durch die Linien 2 angedeutet, die lateralen Begrenzungen des Übertragungskanals von L2 durch die Linien 3. Figur 2 zeigt einen Querschnitt entlang der Linie II-II von Figur 1, der senkrecht zur Bildebene von Figur 1 verläuft. Hieraus ist ersichtlich, daß der Halbleiterkörper 1 an seiner Grenzfläche 1a mit einer dünnen, elektrisch isolierenden Schicht 4, z. B. aus $SiO_2$, bedeckt ist, die eine Gateisolation darstellt. Auf dieser sind die Transferelektroden 5 bis 8 von L1 und 9 bis 12 von L2 angeordnet. Den Elektroden 5 bis 8 werden jeweils die Taktimpulsspannungen $\emptyset 1$ bis $\emptyset 4$ zugeführt. Bei einer im 4-Phasen-Betrieb arbeitenden Anordnung bilden sie daher eine Transferstufe TS1n. Die Transferelektroden 9 und 10, die mit $\emptyset 3$ und $\emptyset 4$ beschaltet sind, stellen einen Teil einer Transferstufe TS2n von L2 dar, während die Elektroden 11 und 12 einen Teil einer zusätzlichen Transferstufe TS2z bilden.

Auf der isolierenden Schicht 4 ist neben den Transfergates 8 und 12 ein Auskopplungsgate 13 vorgesehen. Wie durch die Linie 14 angedeutet ist, vereinigen sich die Übertragungskanäle 2 und 3 unterhalb des Gate 13 zu einem breiteren Übertragungskanal 15. Das Auskopplungsgate 13 ist über einen Schalttransistor TR, dessen Gate mit einer Taktimpulsspannung $\emptyset R$ beschaltet ist, mit einer Referenzspannungsquelle verbunden, die durch einen auf einem Potential $V_R$ liegenden Anschluß 16 angedeutet ist. Außerdem ist das Gate 13 über einen Anschluß A mit dem Gate eines Transistors T1 verbunden, dessen Source-Drain-Strecke über ein Lastelement 17 mit dem Bezugspotential der Schaltung und mit einem an einer Versorgungsspannung $V_{DD}$ liegenden Anschluß 18 verbunden ist. Das Lastelement kann beispielsweise aus einem Feldeffekttransistor des Verarmungstyps bestehen, dessen Gate mit seinem Sourceanschluß verbunden ist. Der Verbindungspunkt zwischen den Teilen T1 und 17 ist mit dem Schaltungsausgang A1 verbunden.

Die CTD-Anordnungen L1 und L2 setzen sich in Figur 1 nach links fort, wobei ihre in herkömmlicher Weise ausgebildeten Eingangsstufen und die ersten n-1 Transferstufen nicht eigens dargestellt sind. Neben dem Auskopplungsgate 13 sind noch ein mit einer Impulsspannung $\emptyset B$ be-schaltetes Gate 19 und ein an der Grenzfläche 1a liegendes Halbleitergebiet 20 mit einer zu dem Halbleiterkörper 1 entgegengesetzten Leitfähigkeit vorgesehen. Das letzter weist einen Anschluß auf, der an der Versorgungsspannung $V_{DD}$ liegt.

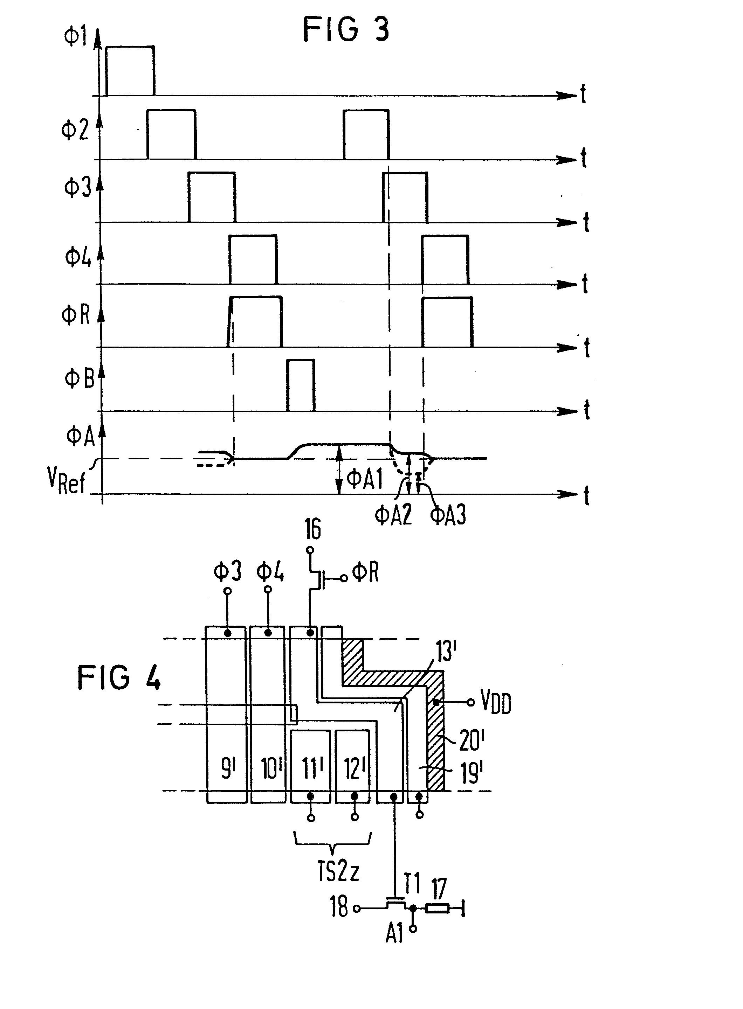

Im Betrieb werden in beiden CTD-Anordnungen unter dem Einfluß der Taktimpulsspannungen $\emptyset 1$ bis $\emptyset 4$ (Figur 3) Ladungspakete, die jeweils einzelnen in den Eingangsstufen abgetasteten Momentanwerten zweier Eingangssignale entsprechen, in Richtung der Pfeile R1 und R2 schrittweise verschoben. Da die Transferstufen beider CTD-Anordnungen, z. B. TS1n und TS2n, um die Breite zweier Transferelektroden in Längsrichtung gegeneinander versetzt sind, gelangt zunächst beim Auftreten eines Takt-impulses $\emptyset 4$ das im Kanal 2 verschobene Ladungspaket unter die Elektrode 8, während das im Kanal 3 verschobene Ladungspaket zu diesem Zeitpunkt unterhalb der Elektrode 10 ist. Durch den Taktimpuls 21 von $\emptyset R$ wird der Transistor TR in den leitenden Zustand geschaltet, so daß das Auskopplungsgate 13 auf das Potential $V_R$ rückgesetzt wird. Nach Beendigung des Taktimpulses $\emptyset 4$ befindet sich das Ladungspaket unterhalb von 13, bewirkt jedoch keine Änderung des Potentials $\emptyset A$ an dem gleichfalls auf $V_R$ rückgesetzten Anschluß A, solange der Impuls 21 andauert. Nach Beendigung des Impulses 21 bewirkt ein

Impuls ØB den Transport des Ladungspaketes in das Gebiet 20, während gleichzeitig das Potential ØA auf einen durch die Größe des Ladungspaketes bestimmten Wert ØA1 ansteigt. Nach Beendigung des nachfolgenden Taktimpulses Ø2 gelangt dann das zweite Ladungspaket aus dem Halbleiterbereich unterhalb der Elektrode 12 in den Bereich unterhalb von 13 und verringert entsprechend seiner Größe das Potential ØA auf einen Wert ØA2 oder ØA3. Die Potentialdifferenz $ØA2-V_R$ bzw. $ØA3-V_R$ entspricht dann der Differenz der in den CTD-Anordnungen L1 und L2 transportierten Ladungspakete nach Betrag und Vorzeichen.

Beim Auftreten des Taktimpulses 22 wird dann ØA wieder auf $V_R$ rückgesetzt. Aus den genannten Potentialdifferenzen am Anschluß A werden über die als Sourcefolger geschaltete Stufe 17, 18 entsprechende Ausgangssignale abgeleitet.

Figur 4 zeigt eine andere nach der Erfindung ausgebildete Schaltung. Bei dieser liegen die Transferstufen beider CTD-Anordnungen, z. B. TS1n und TS2n, nebeneinander, wobei TS2z gegenüber der Stufe TS1n in Längsrichtung verschoben ist. In diesem Fall ist das Auskopplungsgate 13' abgewinkelt, so daß es entsprechend Figur 1 zu den Elektroden 8 und 12' benachbart angeordnet ist. Das Gate 19' und das Gebiet 20' sind entsprechend abgewinkelt ausgebildet.

Nach einer Schaltungsvariante können die Übertragungskanäle der beiden CTD-Anordnungen unterhalb des Auskopplungsgate und unterhalb weiterer, diesem in Übertragungsrichtung folgender Transferelektroden oder Transferstufen voneinander getrennt sein, wie in Figur 1 durch gestrichelte Linien 100 angedeutet ist. Es entfallen dann die Teile 19 bzw. 19' und 20 bzw. 20'. Hierbei können die Ladungspakete auch nach der Differenzbildung weitertransportiert und neuerlich ausgelesen werden, beispielsweise zum Zwecke einer Korrelationsmessung.

Bei den behandelten Ausführungsbeispielen, bei denen von einem p-leitenden Halbleiterkörper ausgegangen wird, weisen die angegebenen Potentiale und Spannungen gegenüber dem Bezugspotential der Schaltung, auf dem der Halbleiterkörper 1 liegt, jeweils positive Vorzeichen auf. Werden die Leitfähigkeitstypen der einzelnen Halbleitergebiete durch die jeweils entgegengesetzten ersetzt, so kehren sich auch die Vorzeichen der Spannungen und Potentiale um.

Obwohl die CTD-Anordnungen der angegebenen Ausführungsbeispiele als SCCD-Anordnungen (Surface-Charge-Coupled Device) ausgebildet sind, kann die Erfindung mit bekannten CTD-Anordnungen beliebiger Art ausgeführt werden, wie sie z. B. in dem Buch von Séquin und Tompsett "Charge Transfer Devices", Academic Press, New York, 1975, auf den Seiten 1 bis 18 beschrieben sind. Die CTD-Anordnungen können dabei entsprechend ihrem Aufbau im 2-, 3-, 4- oder Mehrphasenbereich arbeiten.

5 Patentansprüche
4 Figuren

Patentansprüche.

1. Integrierte Schaltung zur Differenzbildung zwischen zwei Ladungen, die zwei an der Grenzfläche eines dotierten Halbleiterkörpers vorgesehene CTD-Anordnungen durchlaufen, d a d u r c h   g e k e n n z e i c h n e t , daß ein durch eine dünne elektrisch isolierende Schicht (4) von dem Halbleiterkörper (1) getrenntes Auskopplungsgate (13) vorgesehen ist, daß die Übertragungskanäle (2, 3) beider CTD-Anordnungen (L1, L2) unterhalb des für beide gemeinsamen Auskopplungsgate (13) verlaufen, daß das Auskopplungsgate (13) einerseits über einen ersten Schalttransistor (TR) mit einer Referenzspannungsquelle (16) und andererseits mit dem Schaltungsausgang (A1) beschaltet ist und daß eine (L2) der beiden CTD-Anordnungen so ausgebildet ist, daß sie zwischen der dem Auskopplungsgate (13) unmittelbar vorgeordneten vollständigen Transferstufe (TS2n) und dem Auskopplungsgate (13) einen Teil (TS2z) einer weiteren Transferstufe aufweist.

2. Schaltung nach Anspruch 1, d a d u r c h   g e - k e n n z e i c h n e t ,   daß sich das Auskopplungsgate (13) ein mit einer Impulsspannung beschaltetes Gate (19) und ein in lateraler Richtung zu diesem benachbartes Halbleitergebiet (20) mit einem zu dem Halbleiterkörper (1) entgegengesetzten Leitfähigkeitstyp anschließen und daß sich die beiden Übertragungskanäle (2, 3) unterhalb des Auskopplungsgate (13) zu einem für beide CTD-Anordnungen (L1, L2) gemeinsamen Übertragungskanal (15) vereinigen.

3. Schaltung nach Anspruch 1, d a d u r c h   g e - k e n n z e i c h n e t ,   daß die Übertragungskanäle (2, 3) der beiden CTD-Anordnungen (L1, L2) unterhalb des Auskopplungsgate (13) und unterhalb der diesem in Übertragungsrichtung folgenden Transferelektroden voneinander getrennt sind.

4. Schaltung nach einem der Ansprüche 1 bis 3, d a - d u r c h   g e k e n n z e i c h n e t , daß die Transferstufen (TS1n, TS2n) beider CTD-Anordnungen in Übertragungsrichtung (R1, R2) um einen Teil einer Transferstufe (TS2z) gegeneinander versetzt sind und das Auskopplungsgate (13) zwei nebeneinander liegenden Transferelektroden (8, 12) benachbart ist.

5. Schaltung nach einem der Ansprüche 1 bis 3, d a - d u r c h   g e k e n n z e i c h n e t , daß die Transferstufen beider CTD-Anordnungen nebeneinander angeordnet sind und das Auskopplungsgate (13) derart abgewinkelt ist, daß es neben zwei mit unterschiedlichen Taktimpulsspannungen beaufschlagten Transferelektroden (8, 12') liegt.

## FIG 1

## FIG 2

## FIG 3

## FIG 4